# EUROPEAN PATENT SPECIFICATION

(11) **EP 1 816 340 B1**
(45) Date of publication and mention of the grant of the patent: **07.04.2010**
(21) Application number: 06002240.7
(22) Date of filing: 03.02.2006
(51) Int. Cl.: F02M 51/06, F02M 61/16, H01L 41/053

(54) **Fluid injector**
Flüssigkeitsinjector
Injecteur de fluides

(43) Date of publication of application: 08.08.2007
(73) Proprietor: Continental Automotive Italy S.p.A., 56040 Fauglia (PI) (IT)
(72) Inventor: Siringo, Marco, 19124 La Spezia (IT)
(74) Representative: Bonn, Roman Klemens

(56) References cited:
- DE-A1- 10 246 691
- US-B1- 6 422 482

## Description

The invention relates to a fluid injector. Fluid injectors are in wide spread use, in particular for internal combustion engines where they may be arranged in order to dose the fluid into the intake manifold of the internal combustion engine or directly in the combustion chamber of a cylinder of the internal combustion engine.

In order to meet stringent regulations concerning exhaust gas emissions of internal combustion engines, fluid injectors need to be designed such that they are adapted to dose fluid very precisely. In this respect, more and more fluid injectors are equipped with solid state actuators, in particular piezo electric actuators.

In order to reduce exhaust gas emissions of an internal combustion engine one measure is to improve the combustion process in a way to minimize the exhaust gas emissions created during the combustion process. Another measure to reduce the overall exhaust gas emissions is to provide an exhaust gas after treatment system comprising catalytic converters in order to reduce NOx, carbon hydrogens and also sooty particles.

Very precise dosing of fluid by particularly designed fluid injectors sets the basis for reducing exhaust gas emissions created during the combustion process. However, internal combustion engines are operated in a wide range of temperatures and it is therefore important to ensure low emissions in this wide spread temperature range. US 6,422,482 B1 discloses a fuel injection valve comprising a piezo electric actuator, which includes piezo layers and one or more temperature compensation layers. The temperature compensation layers have a temperature expansion coefficient having an operational sign opposite to the sign of the temperature expansion coefficient of the piezo layers. The fuel injector comprises a main body of a valve housing, which takes in the piezo electric actuator.

DE 10246691 A1 discloses a piezo actuator for an injection valve, which comprises a piezo ceramic which is arranged in a housing. The housing is made from a ceramic material being aluminium-nitride, silicon-carbide, silicon-nitride or cordierit-ceramics.

It is an object of the invention to create a fluid injector, which enables precise operation under various operating temperatures.

The object of the invention is achieved by the features of the independent claim. Advantageous embodiments of the invention are given by the sub claims.

The invention is distinguished by a fluid injector with a housing comprising a housing recess taking in an actuator unit comprising a solid state actuator being taken in an actuator housing comprising an actuator tube consisting along an axial extension of the solid state actuator of aluminum titanate. Aluminum titanate, which also may be referred to as aluminum titanium oxide and has the chemical formula of Al₂O₃·TiO₂, is distinguished by that it has a very similar thermal expansion coefficient as typical materials for solid state actuators. This ensures that relative positions between the actuator tube and the solid state actuator are virtually independent from temperature changes. In addition to that aluminum titanate is resistant against corrosion, which may in particular be advantageous, if the actuator unit is operated in an aggressive environment. Further aluminum titanate is suitable for welding, which enables a very simple fixation of the actuator housing to a device, which is actuated upon by the actuator unit.

The fluid injector further comprises a valve body being coupled to the housing and being penetrated by a valve body recess in axial direction. The valve body recess takes in a needle, which prevents in a closing position a dosage of a fluid and enables the dosage of fluid apart from its closing position. The solid state actuator is arranged such, that it acts on the needle and the actuator tube is fixed to the valve body. In view of the advantages according to the first aspect of the invention a thermal compensator may be omitted, which reduces costs for the fluid injector and enables to form the fluid injector more compact as the fluid injector needs less axial extension. This leads to a reduction in the mass of the fluid injector, which is desirable. By having the solid state actuator arranged such, that it acts on the needle and the actuator tube is fixed to the valve body, the actuator housing may be arranged with a clearance in the area of its axial and facing away from the valve body. In this way different thermal compensation coefficients between the actuator housing and the housing of the fluid injector have virtually no influence on the actuator characteristic in view of the actuation on the needle. A very precise dosage of fluid over a wide temperature range is therefore possible. This further ensures that virtually no thermal stress between the actuator housing and valve body or the housing of the fluid injector arises, if the actuator unit is subjected to temperature changes.

According to an advantageous embodiment of the second aspect the actuator housing is surrounded by a fluid duct in its axial end area facing away from the valve body. This enables to on one hand create a clearance between the actuator housing and the housing of the fluid injector and on the other hand to give this a double use by using it as a fluid duct.

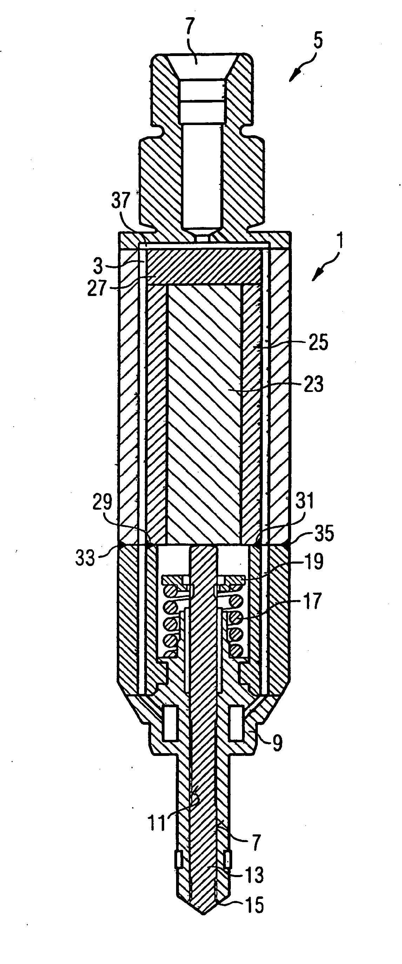

Exemplary embodiments of the invention are explained in the following with the aid of the schematic drawings. The only figure shows a fluid injector with an actuator unit.

A fluid injector may be embodied as a fuel injector, that is suitable for injecting fuel into a gasoline engine or that may be suitable for injecting fuel into a diesel engine.

The fluid injector comprises a housing 1 with a housing recess 3. At one of the axial ends of the housing 1 a fluid supply connecting part 5 is fixed to the housing 1, preferably by welding, in particular laser welding. The fluid supply connecting part 5 comprises a fluid supply recess 7, which is designed to be coupled to a fluid supply in a sealing way and in this way enables fluid communication between the fluid supply and the fluid injector. The fluid supply recess 7 opens out into the housing recess 3.

The housing 1 is in one of its axial end areas fixed to a valve body 9 or may also partly take in the valve body 9. The valve body 9 is preferably fixed to the housing 1 by welding, which is indicated by a dots 33, 35.

The valve body 9 is penetrated in axial direction by a valve body recess 11 taking in a needle 13 and communicating with the housing recess 3. The needle 13 prevents in a closing position the dosage of a fluid through a nozzle 15 and enables the dosage of fluid through the nozzle 15 apart from the closing position. The valve body further takes in a return spring 17, which rests with one of its axial ends on the valve body 9 and rests with its other axial end on a spring washer 19, which is coupled to the needle 13. The return spring 17 pretensions the needle 13 in its closing position without other forces acting on the needle 13.

The actuator unit is also taken in the housing recess 3. The actuator unit comprises a solid state actuator 23, which is preferably a piezo electric actuator comprising a stack of multiple piezo electrical elements, which is preferably pretensioned by a tube spring and may be arranged between a top and a bottom plate, which is not shown. The solid state actuator 23 may also be of a different material than a piezo electric material as it is known to the person skilled in the art for this purpose.

The solid state actuator 23 is coupled on one of its axial ends to the needle 13. The solid state actuator 23 is taken in an actuator housing. The actuator housing comprises an actuator tube 25 extending along the solid state actuator 23 in its axial extension. The actuator housing further comprises an end part 27 on which the solid state actuator 23 rests. The end part 27 therefore forms an axial rest for the solid state actuator 23.

The actuator tube 25 is in the area of its axial end facing towards the nozzle 15 welded to the valve body 9. This is preferably accomplished by welding and respective welding areas are indicated by the dots 29 and 31. Between the axial end of the actuator housing facing away from the nozzle 15 and the fluid supply connecting part 5 a clearance 37 is located which enables a thermal extension of the actuator unit different from the thermal extension of the housing 1 of the fluid injector. The clearance 37 also serves the purpose of a fluid duct from the fluid supply recess 7 over the clearance 37 through the free space of the remaining free space of the housing recess 3 towards the nozzle 15.

As the actuator unit with its housing is fixed to the valve body 9 at its axial end facing the nozzle 15, different thermal expansion coefficients of the valve body 9 or the housing 1 of the fluid injector do virtually have no influence on the relative positions between the respective axial ends of the solid state actuator 23 and the needle 13.

The actuator tube 25 consists of aluminum titanate, which may also be referred to as aluminum titanium oxide and has the chemical formula of Al₂O₃·TiO₂ or Al₂O₅Ti aluminum titanate is synthesized by a solid state reaction of aluminum and titanium at temperatures above 1,350 degrees Celsius. In an intermediate stage the aluminum titanate may be provided in the form of a powder which may then be sintered at temperatures of between 1,400 degrees Celsius and 1,600 degrees Celsius, preferably in air.

The actuator tube 25 made from aluminum titanate exhibits a significantly long operating live, especially in comparison to other materials possibly selected for that purpose. Typically aluminum titanium oxide may also contain a small percentage of magnesium oxide (MgO) of up to 3 percent.

By providing the actuator unit with the actuator tube 25 made from aluminum titanate it is possible to obtain a static flow from the injector, a more efficient and a more reproducible thermal compensation due to the use of mechanical components only. Further to this no-hydraulic concept for thermal compensation may be necessary having as consequence the omission of respective hydraulic sealings and a very high injector outline diameter reduction and a very high fluid injector outline length reduction. In addition to that there may be no necessity of a pin adapter for electrical contacting pins of the solid state actuator 23.

## Claims

1. Fluid injector with a housing (1) comprising a housing recess (3) taking in an actuator unit comprising a solid state actuator (23) being taken in an actuator housing comprising an actuator tube (25), which consists along an axial extension of the solid state actuator (23) of aluminum titanate,and a valve body (9) being coupled to the housing (1) and being penetrated by a valve body recess (11) in axial direction, the valve body recess (11) taking in a needle (13) preventing in a closing position a dosage of fluid and enabling the dosage of fluid apart from the closing position of the needle (13), the solid state actuator (23) being arranged such, that it acts on the needle (13) and the actuator tube (25) being fixed to the valve body (9) by welding.

2. Fluid injector according to claim 1, with the actuator housing being surrounded by a fluid duct in its axial end area facing away from the valve body (9).

## Patentansprüche

1. Fluidinjektor mit einem Gehäuse (1), umfassend eine Gehäuseaussparung (3), die eine Stellgliedeinheit aufnimmt, die ein Festkörperstellglied (23) umfasst, das in einem Stellgliedgehäuse aufgenommen ist, das ein Stellgliedrohr (25) umfasst, das entlang einer axialen Ausdehnung des Festkörperstellglieds (23) aus Aluminiumtitanat besteht, sowie einen Ventilkörper (9), der an das Gehäuse (1) gekoppelt ist und durch eine Ventilkörperaussparung (11) in axialer Richtung durchdrungen wird, während die Ventilkörperaussparung (11) eine Nadel (13) aufnimmt, die in einer Schließstellung eine Dosierung von Fluid verhindert und die Dosierung von Fluid abgesehen von der Schließstellung der Nadel (13) erlaubt, während das Festkörperstellglied (23) derart angeordnet ist, dass es auf die Nadel (13) wirkt und das Stellgliedrohr (25) ist an dem Ventilkörper (9) mittels Schweißen befestigt.

2. Fluidinjektor gemäß Anspruch 1, während das Stellgliedgehäuse durch eine Fluidleitung in seinem axialen Endbereich umgeben ist, der von dem Ventilkörper (9) weg zeigt.

## Revendications

1. Injecteur de fluide comprenant un boîtier (1) dans lequel est prévue une cavité de boîtier (3) ménagée dans une unité d'actionnement comprenant un actionneur (23) à l'état solide disposé dans un logement d'actionneur comprenant un tube d'actionneur (25) s'étendant selon une extension axiale de l'actionneur (23) à l'état solide en titanate d'aluminium, et un corps de soupape (9) couplé au boîtier (1) et percé axialement d'une cavité (11) de corps de soupape, la cavité (11) de corps de soupape recevant une aiguille (13) qui empêche un dosage de fluide dans une position de fermeture et l'autorisant en dehors de cette position de fermeture de l'aiguille (13), l'actionneur (23) à l'état solide étant agencé de telle manière qu'il agisse sur l'aiguille (13), le tube d'actionneur (25) étant fixé par soudage au corps de soupape (9).

2. Injecteur de fluide selon la revendication 1, dans lequel le logement d'actionneur est entouré par un canal de fluide dans la zone d'extrémité axiale opposée au corps de soupape (9).
